# EUROPEAN PATENT APPLICATION

(11) **EP 4 568 426 A1**
(43) Date of publication of application: **11.06.2025**
(21) Application number: 23850181.1
(22) Date of filing: 04.08.2023
(51) Int. Cl.: H05K 1/02, H01L 23/02, H01L 23/12

(54) **WIRING BOARD, ELECTRONIC COMPONENT MOUNTING PACKAGE USING WIRING BOARD, AND ELECTRONIC MODULE**

(30) Priority: 05.08.2022 JP 2022125560
(71) Applicant: Kyocera Corporation, Kyoto-shi, Kyoto 612-8501 (JP)
(72) Inventor: KAWAZU Yoshiki, Kyoto-shi, Kyoto 612-8501 (JP)
(74) Representative: Viering, Jentschura & Partner mbB Patent- und Rechtsanwälte
(86) International application number: PCT/JP2023/028615
(87) International publication number: WO 2024/029628

(57) **Abstract**

A wiring board includes a first insulating layer, a second insulating layer, a first ground conductor, and a first signal conductor. The first insulating layer includes a first upper surface and a first lower surface. The second insulating layer is positioned on the first insulating layer and includes a second upper surface and a second lower surface. The first ground conductor is positioned on the first lower surface and includes a first opening and a second opening. The first signal conductor includes a first line positioned on the first upper surface and a second line positioned on the second lower surface. The first line includes a first end portion and a first line portion. The second line includes a second end portion electrically connected to the first end portion, and a second line portion. In a planar view, the first end portion and the second end portion are positioned in the first opening, and at least part of the second line portion is positioned to be overlapped with the second opening. The first opening is larger in area than the second opening in a planar view.

## Description

### TECHNICAL FIELD

The present disclosure relates to a wiring board, an electronic component mounting package including the wiring board, and an electronic module.

### BACKGROUND OF INVENTION

Electronic modules included in wireless communication devices and optical communication devices have recently been required to deal with higher frequency signals for transmission of information having larger volume at higher speed. Wiring boards configured to transmit signals have thus been required to transmit radio-frequency signals with smaller losses.

A known structure for transmission of such signals includes a signal wiring line for signal transmission, a shield layer made of a conductive material, and an insulating film layer interposed between the signal wiring line and the shield layer. A known technique of adjusting impedance of a circuit board involves providing the shield layer with an opening in such a structure (see Patent Literature 1).

### CITATION LIST

### PATENT LITERATURE

Patent Literature 1: International Publication No. 2010/103722

### SUMMARY

In an embodiment of the present disclosure, (1) a wiring board includes a first insulating layer, a second insulating layer, a first ground conductor, and a first signal conductor. The first insulating layer includes a first upper surface and a first lower surface opposite to the first upper surface. The second insulating layer is positioned on the first insulating layer and includes a second upper surface and a second lower surface opposite to the second upper surface. The first ground conductor includes a first opening and at least one second opening, and is positioned on the first lower surface. The first signal conductor includes a first line positioned on the first upper surface and a second line positioned on the second lower surface. The first line includes a first end portion and a first line portion extending from the first end portion. The second line includes a second end portion electrically connected to the first end portion, and a second line portion extending from the second end portion. The first end portion and the second end portion are positioned in the first opening in a planar view. At least part of the second line portion is positioned to be overlapped with the second opening in a planar view. The first opening is larger in area than the second opening in a planar view.

(2) In the wiring board according to (1) described above, assuming that the first line portion extends in a first direction and a second direction crosses the first direction, the first end portion is smaller in size in the second direction than the second end portion.

(3) In the wiring board according to (1) or (2) described above, the at least one second opening in the first ground conductor includes a plurality of second openings. The plurality of second openings is positioned to be spaced apart from each other along the second line portion in a planar view.

(4) In the wiring board according to (1) to (3) described above, the at least one second opening is larger than the second line portion in size in a direction perpendicular to a direction along the second line portion in a planar view.

(5) In the wiring board according to (1) to (4) described above, a distance between the plurality of second openings in a direction along the second line portion is inconstant in a direction perpendicular to the direction along the second line portion in a planar view.

(6) The wiring board according to (1) to (5) described above further includes a pair of second ground conductors positioned between the first insulating layer and the second insulating layer and electrically connected to the first ground conductor. The first signal conductor is positioned between the pair of second ground conductors in a planar view.

(7) In the wiring board according to (1) to (6) described above, the first insulating layer includes a first side surface connected to the first upper surface and the first lower surface. The second insulating layer includes a second side surface connected to the second upper surface and the second lower surface and positioned inside the first side surface in a planar view. The first upper surface includes a first region positioned between the first side surface and the second side surface in a planar view. The first line includes a first joint portion positioned to extend to the first region in a planar view and connected to an external connector.

(8) In the wiring board according to (7) described above, the first ground conductor includes a single or plurality of third openings positioned to be overlapped with the first joint portion in a planar view.

(9) In the wiring board according to (8) described above, the first insulating layer further includes a concave portion opened in the first region. The concave portion is positioned to be overlapped with at least part of the single or plurality of third openings in a planar view.

(10) The wiring board according to (1) to (9) described above further includes a third ground conductor electrically connected to the first ground conductor and positioned on the second upper surface. The third ground conductor includes a single or plurality of fourth openings. At least part of the second line portion is positioned to be overlapped with the single or plurality of fourth openings in a planar view. The single or plurality of fourth openings includes a portion positioned to be overlapped with at least part of the at least one second opening in a planar view.

(11) According to an embodiment of the present disclosure, an electronic component mounting package includes the wiring board according to (1) to (10) described above, a substrate, and a frame. The frame is bonded to an upper surface of the substrate. The wiring board is fixed to the frame.

(12) According to an embodiment of the present disclosure, an electronic module includes the electronic component mounting package according to (11) described above, an electronic component, and a lid. The electronic component is positioned on the upper surface of the substrate and is electrically connected to the wiring board. The lid is positioned on the frame to cover an interior of the electronic component mounting package.

### BRIEF DESCRIPTION OF THE DRAWINGS

FIG. 1 is a perspective view of a wiring board, an electronic component mounting package, and an electronic module according to an embodiment of the present disclosure.
FIG. 2 is an enlarged view in a different angle, of a principal part A indicated in FIG. 1.
FIG. 3 is an exploded perspective view of the wiring board according to an embodiment of the present disclosure.
FIG. 4 is a plan view of the wiring board according to an embodiment of the present disclosure, excluding a third ground conductor.
FIG. 5 is an enlarged view of a principal part B indicated in FIG. 4.
FIG. 6 is a view obtained by overlapping the third ground conductor on the enlarged view in FIG. 5.
FIG. 7 is a plan view of a first ground conductor.
FIG. 8 is a plan view of a first upper surface.
FIG. 9 is a plan view of a second upper surface.
FIG. 10 is a plan view of the third ground conductor.

### DESCRIPTION OF EMBODIMENTS

### <Configuration of wiring board>

An exemplary embodiment of the present disclosure will be described hereinafter with reference to the drawings. A wiring board may be disposed to include a top or a bottom in any direction. For convenience, the wiring board is defined to have an orthogonal coordinate system xyz, and a positive side in a z direction is assumed to indicate an upper side. The following description refers to a first direction exemplarily indicating a y direction in the drawings. A second direction crossing the first direction exemplarily indicates an x direction in the drawings. An inward direction exemplarily indicates a positive direction of a y axis in the drawings. In the present disclosure, a planar view conceptually includes a plan perspective view.

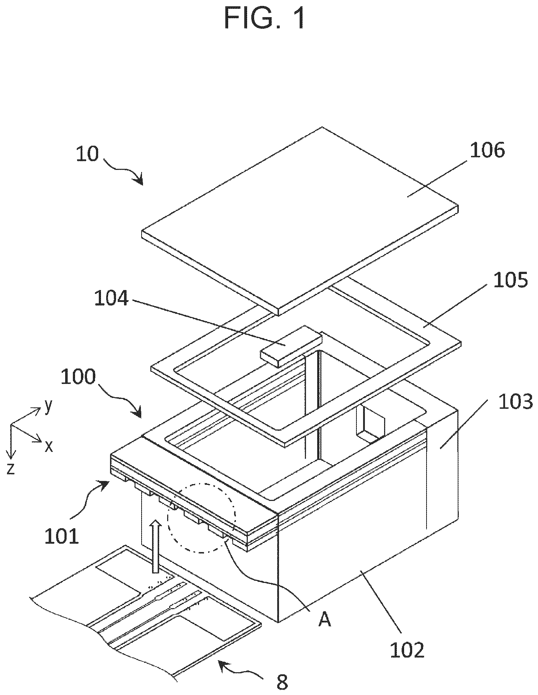

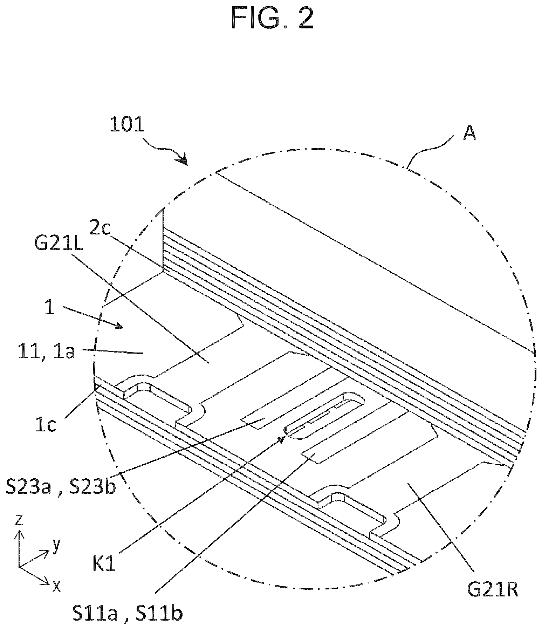

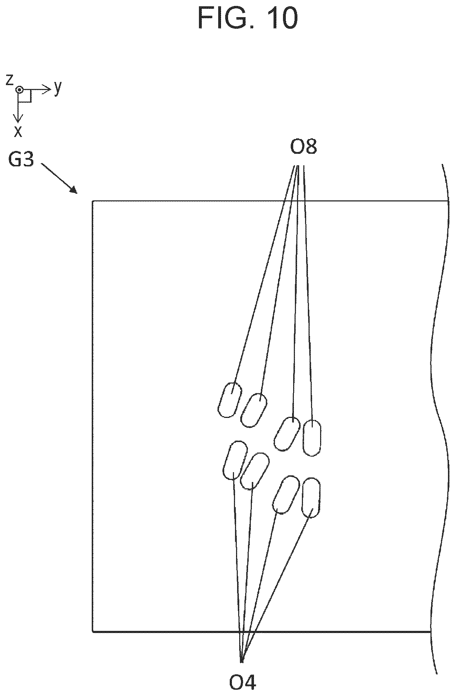

Description is made to a wiring board 101 according to an embodiment of the present disclosure with reference to FIGs. 2 to 10. FIG. 2 is an enlarged view in a positive direction of a z axis, of a principal part A of the wiring board 101, an electronic component mounting package 100, and an electronic module 10 illustrated in FIG. 1. The wiring board 101 includes a first insulating layer 1, a second insulating layer 2, a first ground conductor G1, and a first signal conductor S1.

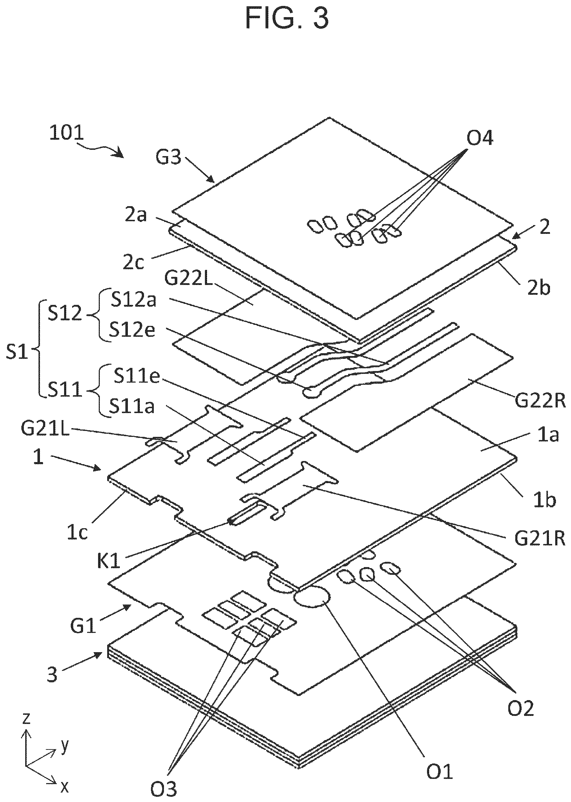

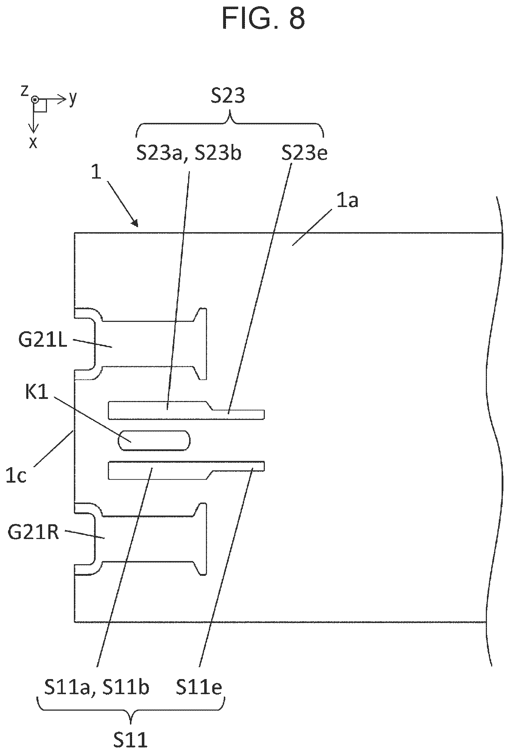

As illustrated in FIGs. 3 and 8, the first insulating layer 1 includes a first upper surface 1a and a first lower surface 1b opposite to the first upper surface 1a. Examples of a material for the first insulating layer 1 can include dielectric materials including a ceramic material such as an aluminum oxide sintered body, a mullite sintered body, a silicon carbide sintered body, an aluminum nitride sintered body, or a silicon nitride sintered body, and a glass ceramic material.

The first insulating layer 1 may be constituted by a single layer or a plurality of stacked insulating layers. The first insulating layer 1 exemplarily has a rectangular shape in a planar view having 4 mm × 4 mm to 50 mm × 50 mm in size and 0.5 mm to 10 mm in thickness.

As illustrated in FIG. 3, the second insulating layer 2 is positioned on the first insulating layer 1, and includes a second upper surface 2a and a second lower surface 2b opposite to the second upper surface 2a. The second insulating layer 2 is made of a material that may be the same as or different from the material for the first insulating layer 1, and examples of the material for the second insulating layer 2 can include materials the same as or similar to the examples of the material for the first insulating layer 1. The second insulating layer 2 may be constituted by a single layer or a plurality of stacked insulating layers. The second insulating layer 2 exemplarily has a rectangular shape in a planar view having 4 mm × 4 mm to 50 mm × 50 mm in size and 0.1 mm to 10 mm in thickness.

As illustrated in FIG. 3, the wiring board 101 may further include a third insulating layer 3 positioned below (adjacent to the first lower surface 1b) the first insulating layer 1. The third insulating layer 3 is made of a material that may be the same as or different from the material for the first insulating layer 1, and examples of the material for the third insulating layer 3 can include materials the same as or similar to the examples of the material for the first insulating layer 1. The third insulating layer 3 may be constituted by a single layer or a plurality of stacked insulating layers. The third insulating layer 3 exemplarily has a rectangular shape in a planar view having 4 mm × 4 mm to 50 mm × 50 mm in size and 0.1 mm to 10 mm in thickness. The third insulating layer 3 may optionally be provided with wiring such as a signal conductor or a ground conductor.

As illustrated in FIGs. 3, 4, and 7, the first ground conductor G1 includes a first opening O1 and a second opening O2, and is positioned on the first lower surface 1b. The first ground conductor G1 is made of a material, examples of which include metallic materials such as gold, silver, copper, nickel, tungsten, molybdenum, and manganese. The first ground conductor G1 may be formed by sintering a metal paste on the first lower surface 1b, or may be formed by applying a thin film forming technique such as an evaporation method or a sputtering method.

The first opening O1 may have a circular shape or a rectangular shape in a planar view. The circular shape herein is not limited to a perfect circle and may be an elliptical shape or a partially lost circle. The second opening O2 may also have a circular shape or a rectangular shape in a planar view. The first opening O1 and the second opening O2 may be identical or different in shape. The first ground conductor G1 may further include a fifth opening O5 and a sixth opening O6.

As illustrated in FIG. 3, the first signal conductor S1 includes a first line S11 positioned on the first upper surface 1a and a second line S12 positioned on the second lower surface 2b. The first signal conductor S1 is made of a material that may be the same as or different from the material for the first ground conductor G1, and examples of the material for the first signal conductor S1 include materials the same as or similar to the examples of the material for the first ground conductor G1. The first line S11 and the second line S12 are not necessarily made of the same or similar materials, and may be made of different materials. The first signal conductor S1 may be formed in the same or a similar manner to the first ground conductor G1. The first signal conductor S1 exemplarily has 0.05 mm to 2 mm in width and 1.5 mm to 25 mm in length. The first signal conductor S1 exemplarily has 0.01 mm to 0.1 mm in thickness. The width, length, and thickness of the first signal conductor S1 herein can be a size in the x direction, a size in the y direction, and a size in the z direction of the first signal conductor S1, respectively.

The first signal conductor S1 includes a surface that may be plated with a metal such as nickel or gold. Part of the first signal conductor S1 may be provided thereon with an insulating film made of a ceramic (e.g., alumina coating), a resin, or the like. The insulating film can be formed on the first signal conductor S1 by screen printing. The insulating film may alternatively be positioned only on part of the first signal conductor S1. Such a configuration is less likely to cause a short circuit between the first signal conductor S1 and other wiring.

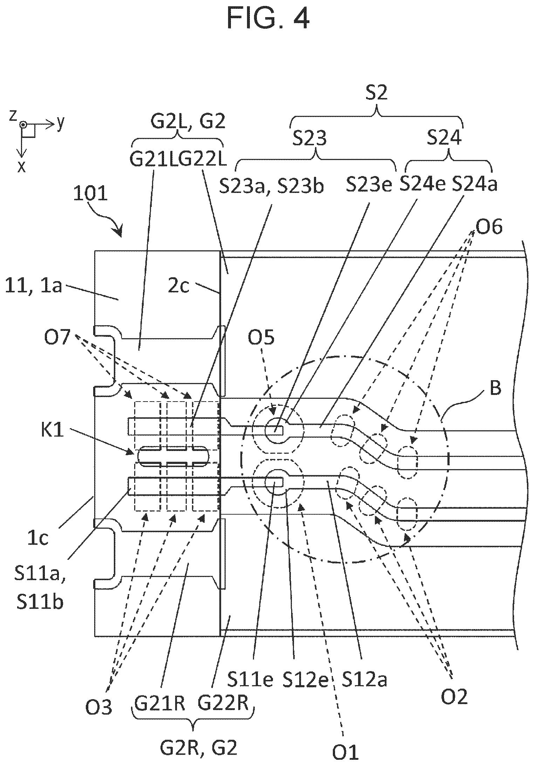

As illustrated in FIG. 4, the wiring board 101 may further include a second signal conductor S2 aligned with the first signal conductor S1. In such a configuration, the first signal conductor S1 and the second signal conductor S2 can serve as a pair of signal conductors configured to transmit differential signals. The second signal conductor S2 is made of a material that may be the same as or different from the material for the first ground conductor G1, and examples of the material for the second signal conductor S2 include materials the same as or similar to the examples of the material for the first ground conductor G1. Furthermore, the second signal conductor S2 may include a third line S23 positioned on the first upper surface 1a and a fourth line S24 positioned on the second lower surface 2b.

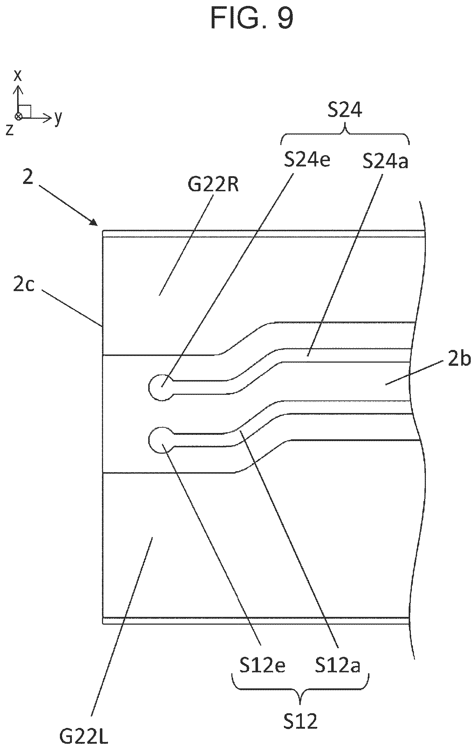

As illustrated in FIG. 8, the first line S11 includes a first end portion S11e and a first line portion S11a extending from the first end portion S11e. As illustrated in FIG. 9, the second line S12 includes a second end portion S12e electrically connected to the first end portion S11e and a second line portion S12a extending from the second end portion S12e. The first end portion S11e and the second end portion S12e may be positioned to be overlapped with each other in a planar view. In an embodiment, the first end portion S11e is in direct contact with the second end portion S12e and is overlapped with the second end portion S12e in a planar view. This configuration does not need connection between the first end portion S11e and the second end portion S12e by a via conductor to achieve reductions in the height and the size of the wiring board 101. The first end portion S11e and the second end portion S12e may be connected by a via conductor or a castellation. In this case, the first insulating layer 1 and the second insulating layer 2 interpose another insulating layer that is provided with a via or a castellation to electrically connect the first end portion S11e and the second end portion S12e.

As illustrated in FIGs. 4, 8, and 9, when the wiring board 101 further includes the third line S23 and the fourth line S24, the third line S23 may include a third end portion S23e and a third line portion S23a extending from the third end portion S23e. The fourth line S24 may include a fourth end portion S24e and a fourth line portion S24a extending from the fourth end portion S24e. In this case, the third end portion S23e, the third line portion S23a, the fourth end portion S24e, and the fourth line portion S24a can be configured identically or similarly to the first end portion S11e, the first line portion S11a, the second end portion S12e, and the second line portion S12a, respectively.

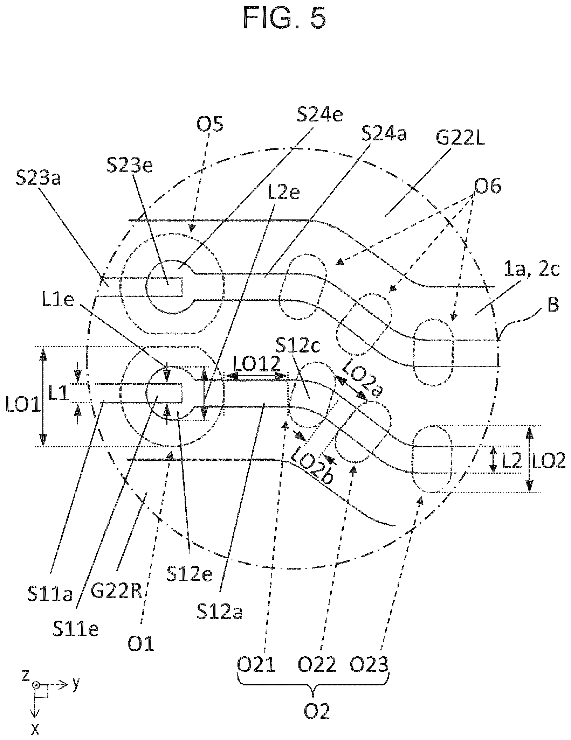

As illustrated in FIGs. 4 and 5, the first end portion S11e and the second end portion S12e are positioned in the first opening O1 in a planar view. At least part of the second line portion S12a is positioned to be overlapped with the second opening O2 in a planar view. The first opening O1 is larger in area than the second opening O2 in a planar view. The wiring board 101 thus configured can adjust impedance at an appropriate value on the second line portion S12a and at a location where the first end portion S11e and the second end portion S12e are electrically connected to each other. This is described hereinafter.

Provision of a ground conductor below a signal conductor on a microstrip line typically causes a shift of a resonance frequency to a higher frequency to achieve excellent radio-frequency signal transmission characteristics. Meanwhile, a signal conductor and a ground conductor closer to each other tend to have a lower impedance, and thus need impedance matching. In contrast, in an embodiment, the first ground conductor G1 includes the second opening O2 positioned to be overlapped with at least part of the second line portion S12a in a planar view. This configuration can maintain a desired resonance frequency on the second line portion S12a as well as can reduce an impedance decrease to achieve adjustment of impedance at a desired value.

Furthermore, characteristic impedance may be decreased at the location where the first end portion S11e and the second end portion S12e are electrically connected to each other as in an embodiment. Impedance mismatching thus needs to be reduced at the location rather than on the second line portion S12a. Accordingly, in a planar view, the first end portion S11e and the second end portion S12e are positioned in the first opening O1 and the first opening O1 is made larger in area than the second opening O2, so as to adjust impedance at a desired value at a jointing portion between the first end portion S11e and the second end portion S12e as well as on the second line portion S12a.

As illustrated in FIGs. 4 to 7, when the first ground conductor G1 includes the fifth opening O5 and the sixth opening O6, the fifth opening O5 and the sixth opening O6 can be configured identically or similarly to the first opening O1 and the second opening O2, respectively.

The wiring board 101 may include a plurality of signal lines each corresponding to the first signal conductor S1 or the second signal conductor S2. In this case, the first ground conductor G1 may include a plurality of first openings O1, a plurality of second openings O2, a plurality of fifth openings O5, and a plurality of sixth openings O6 so as to correspond to the plurality of first signal conductors S1 and/or the plurality of second signal conductors S2.

As illustrated in FIG. 5, assuming that the first line portion S11a extends in the first direction (y direction) and the second direction (x direction) crosses the y direction, the first end portion S11e has a size L1e in the second direction (x direction), which may be smaller than a size L2e in the second direction (x direction) of the second end portion S12e. That is, the first end portion S11e may be smaller in width than the second end portion S12e. Even if the first line S11 provided on the first insulating layer 1 and the second line S12 provided on the second insulating layer 2 are stacked with displacement, such a configuration facilitates electrical connection between the first line S11 and the second line S12. In other words, the first end portion S11e and the second end portion S12e can easily be positioned to be overlapped with each other in a planar view.

As illustrated in FIG. 5, the second end portion S12e has a circular shape in an embodiment. This configuration is less likely to cause disconnection at a jointing portion between the first line S11 and the second line S12. The circular shape herein is not limited to a perfect circle and may be an elliptical shape or a partially lost circle. The second end portion S12e may alternatively have a rectangular shape or a polygonal shape.

The size L1e in the x direction of the first end portion S11e and a size L1 in the x direction of the first line portion S11a are equal to each other in an embodiment, and may alternatively be different from each other.

Furthermore, the size L2e in the x direction of the second end portion S12e is larger than a size L2 in the x direction of the second line portion S12a in an embodiment. Alternatively, the size L2e in the x direction of the second end portion S12e may be equal to the size L2 in the x direction of the second line portion S12a.

As illustrated in FIGs. 4 and 5, the first ground conductor G1 may include a plurality of second openings O2 (O21, O22, and O23). In this case, the plurality of second openings O2 may be positioned to be spaced apart from each other along the second line portion S12a in a planar view. Such a configuration can maintain the resonance frequency on the second line portion S12a as well as can reduce an impedance decrease to facilitate adjustment of impedance at a desired value. The number of the second openings O2 is three (O21, O22, and O23) in an embodiment. Alternatively, the number of the second openings O2 may be two, or four or more. The number of the second openings O2 can be determined in accordance with length of the second line portion S12a and a required impedance value. As illustrated in FIG. 5, the first opening O1 and the second opening O2 have a minimum distance LO12 in the y direction, which may be larger than distances LO2a and LO2b to be described later.

As illustrated in FIGs. 4 and 5, the second openings O2 have a size LO2 that may be larger than the size L2 of the second line portion S12a in a direction perpendicular to a direction along the second line portion S12a in a planar view. Such a configuration can maintain the resonance frequency on the second line portion S12a as well as can reduce an impedance decrease to facilitate adjustment of impedance at a desired value. Even if the second insulating layer 2 provided with the second line portion S12a is stacked on the first insulating layer 1 with displacement, the second opening O2 can be positioned to be overlapped with the second line portion S12a in a planar view in such a configuration as described above. Herein, the direction along the second line portion S12a corresponds to the y direction in a portion of the second line portion S12a positioned to extend linearly in the y direction. When the second line portion S12a includes a curved portion S12c curved as illustrated in FIG. 4, the direction along the second line portion S12a corresponds to a direction of a tangent of the second line portion S12a in the curved portion S12c.

As illustrated in FIG. 5, a distance in the direction along the second line portion S12a between the plurality of second openings O2 may be inconstant in the direction perpendicular to the direction along the second line portion S12a in a planar view. Description is made with exemplary reference to the single second opening O21 and the different second opening O22. As illustrated in FIG. 5, assume that the distance LO2a corresponds to a distance in the direction along the second line portion S12a between the second opening O21 and the second opening O22 at appropriate points, and the distance LO2b corresponds to a distance in the direction along the second line portion S12a between the second opening O21 and the second opening O22 at other appropriate points. The distance LO2a and the distance LO2b are different from each other in this case. Such a configuration is less likely to cause interference between the plurality of second openings O2, as well as can achieve an increase in the area of the second openings O2. This configuration can maintain a desired resonance frequency on the second line portion S12a as well as can reduce an impedance decrease to facilitate adjustment of impedance at a desired value.

As illustrated in FIG. 5, in an embodiment, the second line portion S12a includes the curved portion S12c curved in a positive direction of an x axis. The distance LO2a can be set as a distance between the second openings O2 inside the curved portion S12c (a positive side of the x axis with respect to the second line portion S12a), and the distance LO2b can be set as a distance between the second openings O2 outside the curved portion S12c (a negative side of the x axis with respect to the second line portion S12a). In this case, establishment of LO2a > LO2b can further effectively achieve the above effect. That is, the above effect can preferably be achieved by slantly positioning the second openings O2 so as to follow the second line portion S12a and the curved portion S12c in a planar view.

As illustrated in FIGs. 2 to 4, the wiring board may further include a pair of second ground conductors G2 positioned between the first insulating layer 1 and the second insulating layer 2 and electrically connected to the first ground conductor G1. In this case, the first signal conductor S1 is positioned between the pair of second ground conductors G2 in a planar view. The first signal conductor S1 is aligned with the second ground conductors G2 in such a configuration, to achieve a coplanar structure of the first signal conductor S1 as a signal wiring line. The coplanar structure achieves smooth transmission of radio-frequency signals. More specifically, the pair of second ground conductors G2 may include a second left ground conductor G2L and a second right ground conductor G2R as illustrated in FIG. 4. The second left ground conductor G2L may include a second left external ground conductor G21L aligned with the first line S11, and a second left internal layer ground conductor G22L aligned with the second line S12. The second right ground conductor G2R may include a second right external ground conductor G21R aligned with the first line S11, and a second right internal layer ground conductor G22R aligned with the second line S12.

As illustrated in FIGs. 1 to 4, the first insulating layer 1 may further include a first side surface 1c connected to the first upper surface 1a and the first lower surface 1b. The second insulating layer 2 may include a second side surface 2c connected to the second upper surface 2a and the second lower surface 2b and positioned inside and spaced apart from the first side surface 1c in a planar view. In this case, the first upper surface 1a includes a first region 11 positioned between the first side surface 1c and the second side surface 2c in a planar view. The first line S11 may include a first joint portion S11b positioned to extend to the first region 11 in a planar view and connected to an external connector 8. Such a configuration enables transmission and reception of electrical signals directly to and from the external connector 8 or via the external connector 8. In the present disclosure, the external connector 8 conceptually includes a flexible printed circuit (FPC), a wire, a connector such as a lead terminal, and a printed circuit board (PCB) provided with an electronic circuit.

As illustrated in FIG. 1, the external connector 8 is a flexible printed circuit in an embodiment. When the external connector 8 connected to the wiring board 101 is a wire or a connector such as a lead terminal, the connector may be connected to a circuit board such as a printed circuit board.

The wiring board 101 may be connected to a printed circuit board by a solder ball or the like. That is, the wiring board 101 may be mounted on the printed circuit board by a ball grid array (BGA).

When the wiring board 101 further includes the pair of second ground conductors G2 (the second left ground conductor G2L and the second right ground conductor G2R), a ground conductor of the external connector 8 may be connected to the second left external ground conductor G21L and the second right external ground conductor G21R.

When the wiring board 101 further includes the third line S23 (the third line portion S23a and the third end portion S23e), the third line S23 may include a second joint portion S23b positioned to extend to the first region 11 in a planar view and connected to the external connector 8.

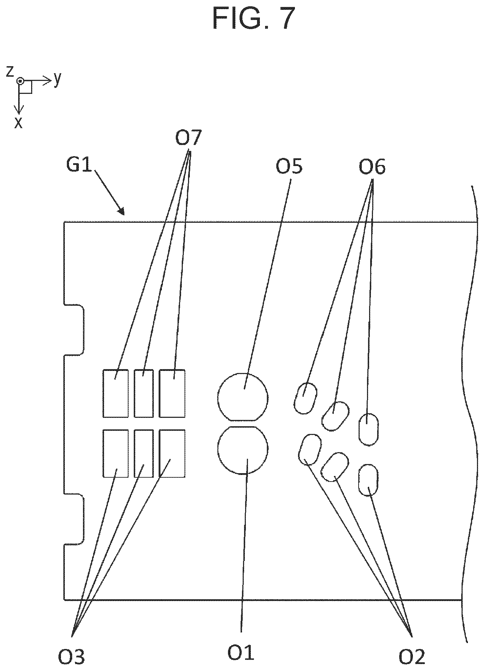

As illustrated in FIGs. 4 and 7, the first ground conductor G1 may include a single or plurality of third openings O3 positioned to be overlapped with the first joint portion S11b in a planar view. Such a configuration is less likely to cause a decrease in impedance value at the first joint portion S11b.

When the wiring board 101 further includes the second joint portion S23b, the first ground conductor G1 may include a single or plurality of seventh openings O7 positioned to be overlapped with the second joint portion S23b in a planar view.

As illustrated in FIGs. 2 to 4, the first insulating layer 1 may further include a concave portion K1 opened in the first region 11. In this case, the concave portion K1 may be positioned to be overlapped with part of the single or plurality of third openings O3 in a planar view. Provision of the concave portion K1 can decrease a relative dielectric constant in a portion provided with the concave portion K1, so as to reduce a decrease in impedance value on the first line S11.

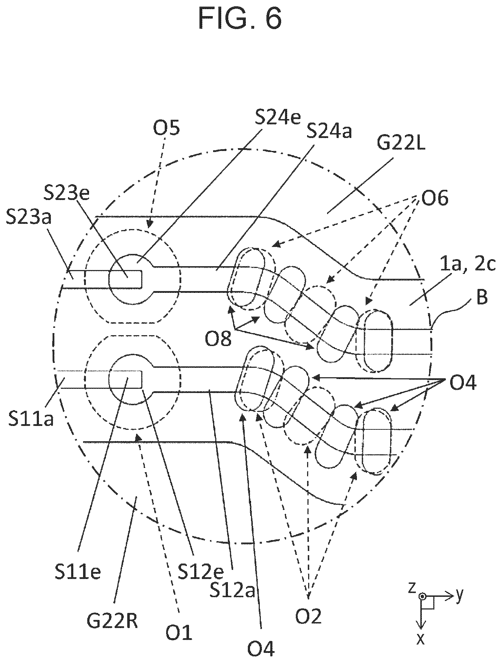

As illustrated in FIGs. 6, 7, and 10, the wiring board 101 may further include a third ground conductor G3 electrically connected to the first ground conductor G1 and positioned on the second upper surface 2a. Furthermore, the third ground conductor G3 may include a single or plurality of fourth openings O4. At least part of the second line portion S12a is positioned to be overlapped with the single or plurality of fourth openings O4 in a planar view. The single or plurality of fourth openings O4 includes a portion positioned to be overlapped with part of the second opening O2 in a planar view. In other words, the single or plurality of fourth openings O4 may be displaced from the single or plurality of third openings O3 in a planar view. Such a configuration achieves a stripline structure of the second line S12, and can maintain the resonance frequency on the second line portion S12a as well as can adjust to reduce a decrease in impedance value.

When the wiring board 101 further includes the fourth line S24 (the fourth line portion S24a and the fourth end portion S24e), the third ground conductor G3 may include a single or plurality of eighth openings O8. In this case, at least part of the fourth line portion S24a may be positioned to be overlapped with the single or plurality of eighth openings O8 in a planar view. As illustrated in FIG. 6, the single or plurality of eighth openings O8 may include a portion positioned to be overlapped with part of the sixth opening O6 in a planar view.

### <Configuration of electronic component mounting package>

As illustrated in FIG. 1, according to an embodiment of the present disclosure, the electronic component mounting package 100 includes the wiring board 101, a substrate 102, and a frame 103. The frame 103 is bonded to an upper surface of the substrate 102, and the wiring board 101 is fixed to the frame 103. The wiring board 101 may alternatively be bonded to the upper surface of the substrate 102.

The substrate 102 includes the upper surface. The substrate 102 exemplarily has a quadrilateral shape in a planar view having 10 mm × 10 mm to 50 mm × 50 mm in size and 0.5 mm to 20 mm in thickness. The substrate 102 is made of a material, examples of which include metallic materials such as copper, iron, tungsten, molybdenum, nickel, and cobalt, and an alloy containing some of these metallic materials. In this case, the substrate 102 may be constituted by a single metal plate or a stacked body including a plurality of stacked metal plates. When the substrate 102 is made of any one of the above metallic materials, the substrate 102 may be provided on its surface with a plated layer of nickel, gold, or the like in accordance with an electroplating method or an electroless plating method for suppression of oxidation corrosion. The substrate 102 may alternatively be made of an insulating material, examples of which include a ceramic material such as an aluminum oxide sintered body, a mullite sintered body, a silicon carbide sintered body, an aluminum nitride sintered body, a silicon nitride sintered body, or a glass ceramic.

The substrate 102 may alternatively be a PCB including a printed electric circuit. The wiring board 101 may be bonded to the substrate 102 by a BGA in this case.

The frame 103 is positioned on the upper surface of the substrate 102 and protects an electronic component 104 positioned in the frame 103 in a planar view. That is, the frame 103 is positioned to surround the electronic component 104 in a planar view. As illustrated in FIG. 1, the frame 103 and the wiring board 101 surround an outer edge of the upper surface of the substrate 102 in an embodiment. In this manner, the frame 103 does not need to surround the entire outer edge of the upper surface of the substrate 102. The frame 103 is positioned along the outer edge of the upper surface of the substrate 102 in an embodiment. Alternatively, the frame 103 may be positioned inside the outer edge of the upper surface of the substrate 102.

The frame 103 may have a rectangular shape in a planar view. In this case, the wiring board 101 may be bonded to a lower surface of the frame 103. When the wiring board 101 is bonded to the upper surface of the substrate 102, the wiring board 101 may be interposed between the frame 103 and the substrate 102.

The frame 103 is made of a material, examples of which may include metallic materials such as copper, iron, tungsten, molybdenum, nickel, and cobalt, and an alloy containing some of these metallic materials. The frame 103 may alternatively be made of an insulating material, examples of which include a ceramic material such as an aluminum oxide sintered body, a mullite sintered body, a silicon carbide sintered body, an aluminum nitride sintered body, a silicon nitride sintered body, or a glass ceramic.

The frame 103 can be bonded to the substrate 102 via a brazing filler metal or the like. The brazing filler metal is made of a material, examples of which include silver, copper, gold, aluminum, and magnesium, and may contain an additive such as nickel, cadmium, or phosphorus.

### <Configuration of electronic module>

As illustrated in FIG. 1, the electronic module 10 includes the electronic component mounting package 100, the electronic component 104, and a lid 106. The electronic module 10 may further include a seal ring 105.

The electronic component 104 may be configured to process a signal, e.g., convert an optical signal to an electrical signal or convert an electrical signal to an optical signal. The electronic component 104 is positioned on the upper surface of the substrate 102, and is accommodated in the electronic component mounting package 100.

Examples of the electronic component 104 include an optical semiconductor element such as a semiconductor laser (LD) or a photodiode (PD), a semiconductor integrated circuit element, and a sensor element such as an optical sensor. The electronic component 104 can be made of a semiconductor material such as gallium arsenide or gallium nitride. When the electronic component 104 is an optical semiconductor element, the electronic module 10 can be utilized as an optical communication module.

The lid 106 is positioned on the frame 103 to cover an interior of the electronic component mounting package 100, such that the lid 106 and the frame 103 protect the electronic component 104. The lid 106 exemplarily has a quadrilateral shape in a planar view having 10 mm × 10 mm to 50 mm × 50 mm in size and 0.5 mm to 2 mm in thickness. The lid 106 is made of a material, examples of which include metallic materials such as iron, copper, nickel, chrome, cobalt, molybdenum, and tungsten, and an alloy obtained by combining some of these metallic materials. A metal member constituting the lid 106 can be manufactured by applying a metalworking method such as a metal rolling method or a punching method to an ingot made of such a metallic material.

The seal ring 105 has a function to bond the lid 106 and the frame 103. The seal ring 105 is positioned on the frame 103 to surround the electronic component 104 in a planar view. The seal ring 105 is made of a material, examples of which include metallic materials such as iron, copper, silver, nickel, chrome, cobalt, molybdenum, and tungsten, and an alloy obtained by combining some of these metallic materials. When the seal ring 105 is not provided on the frame 103, the lid 106 may be bonded via a bonding material such as solder, a brazing filler metal, glass, or a resin adhesive.

In an embodiment, characterized portions may be combined variously without being limited to exemplifications according to the above embodiment. Furthermore, combination is applicable among embodiments.

According to an embodiment, the wiring board configured as described above more appropriately achieves impedance adjustment, and can thus improve signal transmission characteristics on a signal wiring line. This achieves provision of the electronic component mounting package and the electronic module that can reduce losses in transmission of signals, particularly radio-frequency signals.

### INDUSTRIAL APPLICABILITY

The present disclosure is applicable to a wiring board, an electronic component mounting package including the wiring board, and an electronic module.

### REFERENCE SIGNS

1 first insulating layer
1a first upper surface
1b first lower surface
1c first side surface
11 first region
2 second insulating layer
2a second upper surface
2b second lower surface
2c second side surface
G1 first ground conductor
G2 second ground conductor
G2L second left ground conductor
G21L second left external ground conductor
G22L second left internal layer ground conductor
G2R second right ground conductor
G21R second right external ground conductor
G22R second right internal layer ground conductor
G3 third ground conductor
O1 first opening
O2 (O21 to O23) second opening
O3 third opening
O4 fourth opening
O5 fifth opening
O6 sixth opening
O7 seventh opening
K1 concave portion
S1 first signal conductor
S11 first line
S11a first line portion
S11b first joint portion
S11e first end portion
S12 second line
S12a second line portion
S12e second end portion
S2 second signal conductor
S23 third line
S23a third line portion
S23e third end portion
S23b second joint portion
S24 fourth line
S24a fourth line portion
S24e fourth end portion
L1 size of first line portion
L1e size of first end portion
L2 size of second line portion
L2e size of second end portion
LO1 size of first opening
LO2 size of second opening
8 external connector
10 electronic module
100 electronic component mounting package
101 wiring board
102 substrate
103 frame
104 electronic component
105 seal ring
106 lid

## Claims

1. A wiring board comprising:
a first insulating layer including a first upper surface and a first lower surface opposite to the first upper surface;
a second insulating layer positioned on the first insulating layer and including a second upper surface and a second lower surface opposite to the second upper surface;
a first ground conductor including a first opening and at least one second opening, and positioned on the first lower surface; and
a first signal conductor including a first line positioned on the first upper surface and a second line positioned on the second lower surface; wherein
the first line includes a first end portion and a first line portion extending from the first end portion,
the second line includes a second end portion electrically connected to the first end portion, and a second line portion extending from the second end portion,
in a planar view,
the first end portion and the second end portion are positioned in the first opening,
at least part of the second line portion is positioned to be overlapped with the second opening, and
the first opening is larger in area than the second opening.

2. The wiring board according to claim 1, wherein
assuming that the first line portion extends in a first direction and a second direction crosses the first direction,
the first end portion is smaller in size in the second direction than the second end portion.

3. The wiring board according to claim 1 or 2, wherein
the at least one second opening in the first ground conductor includes a plurality of second openings, and
the plurality of second openings is positioned to be spaced apart from each other along the second line portion in a planar view.

4. The wiring board according to any one of claims 1 to 3, wherein
the at least one second opening is larger than the second line portion in size in a direction perpendicular to a direction along the second line portion in a planar view.

5. The wiring board according to any one of claims 1 to 4, wherein
a distance between the plurality of second openings in a direction along the second line portion is inconstant in a direction perpendicular to the direction along the second line portion in a planar view.

6. The wiring board according to any one of claims 1 to 5, the wiring board further comprising
a pair of second ground conductors positioned between the first insulating layer and the second insulating layer and electrically connected to the first ground conductor, wherein
the first signal conductor is positioned between the pair of second ground conductors in a planar view.

7. The wiring board according to any one of claims 1 to 6, wherein
the first insulating layer includes a first side surface connected to the first upper surface and the first lower surface,
the second insulating layer includes a second side surface connected to the second upper surface and the second lower surface and positioned inside the first side surface in a planar view,
the first upper surface includes a first region positioned between the first side surface and the second side surface in a planar view, and
the first line includes a first joint portion positioned to extend to the first region in a planar view and connected to an external connector.

8. The wiring board according to claim 7, wherein
the first ground conductor includes a single or plurality of third openings positioned to be overlapped with the first joint portion in a planar view.

9. The wiring board according to claim 8, wherein
the first insulating layer further includes a concave portion opened in the first region, and
the concave portion is positioned to be overlapped with at least part of the single or plurality of third openings in a planar view.

10. The wiring board according to any one of claims 1 to 9, the wiring board further comprising
a third ground conductor electrically connected to the first ground conductor and positioned on the second upper surface, wherein
the third ground conductor includes a single or plurality of fourth openings,
at least part of the second line portion is positioned to be overlapped with the single or plurality of fourth openings in a planar view, and
the single or plurality of fourth openings includes a portion positioned to be overlapped with at least part of the at least one second opening in a planar view.

11. An electronic component mounting package comprising:
a substrate;
a frame bonded to an upper surface of the substrate; and
the wiring board according to any one of claims 1 to 10, the wiring board fixed to the frame.

12. An electronic module comprising:
the electronic component mounting package according to claim 11;
an electronic component positioned on the upper surface of the substrate and electrically connected to the wiring board; and
a lid positioned on the frame to cover an interior of the electronic component mounting package.
